**Europäisches Patentamt**

**European Patent Office**

**Office européen des brevets**

(11) Publication number: **0 421 476 A2**

# EUROPEAN PATENT APPLICATION

(21) Application number: **90119191.6**

(22) Date of filing: **05.10.90**

(51) Int. Cl.5: **H01L 21/28**, H01L 21/336, H01L 31/18

(30) Priority: **05.10.89 JP 260786/89**

(43) Date of publication of application:
**10.04.91 Bulletin 91/15**

(84) Designated Contracting States:
**DE FR GB**

(71) Applicant: **MATSUSHITA ELECTRIC INDUSTRIAL CO., LTD.**
**1006, Oaza Kadoma**
**Kadoma-shi, Osaka-fu, 571(JP)**

(72) Inventor: **Ishihara, Shinichiro**
**5-25-5, Nanpeidai**
**Takatsuki-shi, Osaka(JP)**

(74) Representative: **Eisenführ, Speiser & Strasse**
**Martinistrasse 24**
**W-2800 Bremen 1(DE)**

(54) Method of manufacturing a semiconductor device.

(57) An improved method for manufacturing a semiconductor device which comprises the following steps: (a) providing a first substrate, (b) depositing at least one thin film on the first substrate, (c) processing a first principal plane of the at least one thin film, the first principal plane being further from the first substrate than a second principal plane which faces the first substrate, (d) adhering a support to the first principal plane of the at least one thin film, (e) removing the first substrate from the at least one thin film adhered to the support, and (f) processing the at least one thin film on the second principal plane, and a composite structure for performing the method.

*Fig. 1*

EP 0 421 476 A2

# METHOD OF MANUFACTURING A SEMICONDUCTOR DEVICE

## BACKGROUND OF THE INVENTION

The present invention relates to a method for manufacturing a semiconductor device comprising thin film layers and a composite structure used in the method.

Semiconductor devices comprising thin film layers are manufactured by using photolithography or the like.

Previously, many semiconductor devices were manufacutured by processing only one principal plane of thin films formed on a substrate. For example, in minute processing which typically includes manufacturing an . integrated circuit, only one principal plane of monocrystalline silicon was processed.

One of the exceptions was for example a solar cell of monocrystalline silicon, which is manufactured by applying a dispersion of a photosensitive substance on a first principal plane of monocrystalline silicon as a substrae so as to provide a surface electrode thereon, and then forming the other electrode on the second principal plane of the substrate. That is, a semiconductor device is manufactured by processing both principal planes of the solar cell.

In a method for manufacturing a semiconductor device by processing only one principal plane, as the steps for manufacture become more complicated, the positioning of a photomask on the substrate becomes harder, so that dust or damage generated in preceding steps are liable to cause an inferior device.

## SUMMARY OF THE INVENTION

An object of the present invention is to provide a method for manufacturing a semiconductor device more precisely.

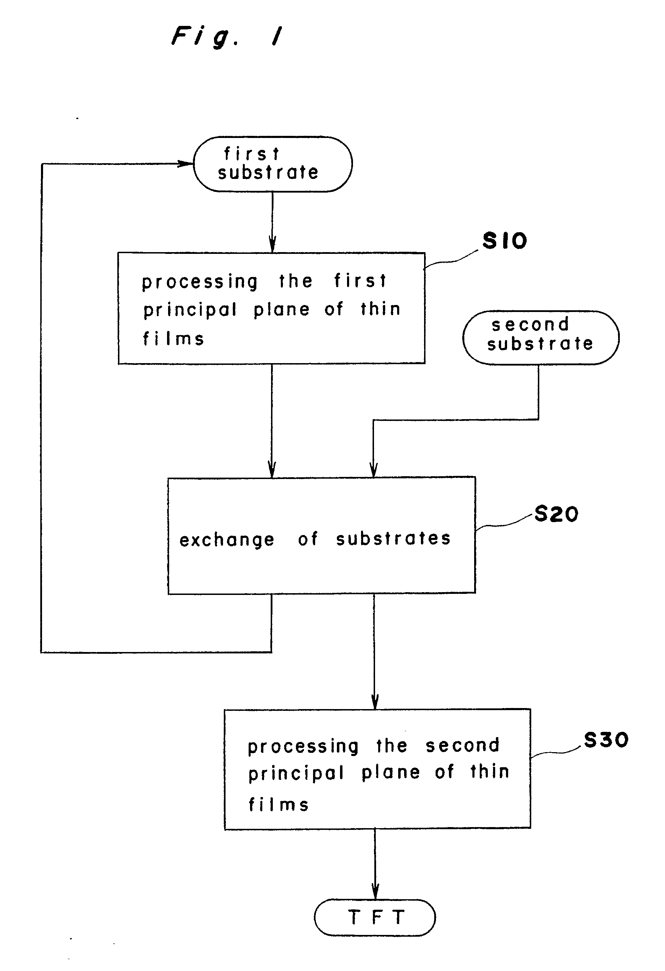

A method for manufacturing a semiconductor device according to the present invention comprises, as shown in Figure 1, the steps of processing thin films formed on a first substrate on a first principal plane of the thin films, which first principal plane is a principal plane furthest from the first substrate than a second principal plane which faces the first substrate (Step 10); adhering a support to the first principal plane of the thin films, and removing the first substrate from the thin films adhered to the support (Step 20); and processing thin films formed on the support on the second principal plane (Step 30).

An advantage of the present invention is that the positioning of a photomask on the substrate becomes more precise.

## BRIEF EXPLANATION OF THE DRAWINGS

Other objects and advantage of the invention will be apparent from the following description, the appended claims and the accompanying drawings, in which,

Figure 1 is a flowchart of a process according to the invention,

Figures 2(a) and 2(b) are flowcharts of a process according to an embodiment of the invention,

Figure 3 is a schematic sectional view of a semiconductor device at Step 116,

Figure 4 is a schematic sectional view of a semiconductor device at Step 118,

Figure 5 is a schematic sectional view of a semiconductor device at Step 126,

Figure 6 is a schematic sectional view of a semiconductor device at Step 202,

Figure 7 is a schematic sectional view of a semiconductor device at Step 204,

Figure 8 is a schematic sectional view of a semiconductor device transferred to a transparent substrate,

Figure 9 is a schematic sectional view of a semiconductor device at Step 304,

Figure 10 is a schematic sectional view of a semiconductor device at Step 316, and

Figure 11 is a schematic sectional view of a semiconductor device at Step 324.

## EMBODIMENT

Referring now to the drawings, wherein like reference characters designate like or corresponding parts throughout the several views, an embodiment of the present invention will be explained in detail. The embodiment relates to a method for manufacturing thin film transistors (TFT) as a switching element array for driving liquid crystal of a liquid crystal television display, and electrodes for transmitting signals to the thin film transistors.

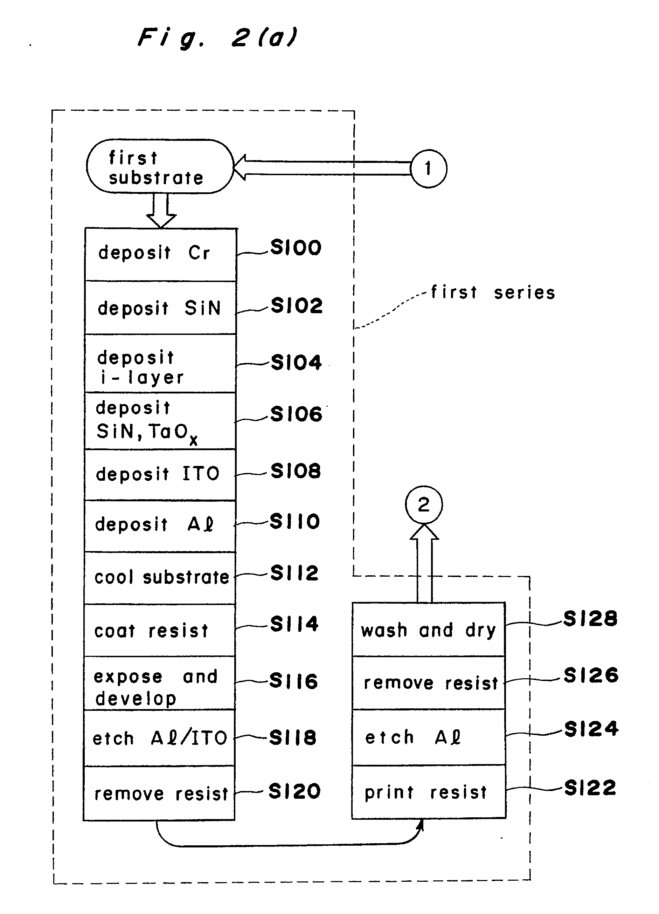

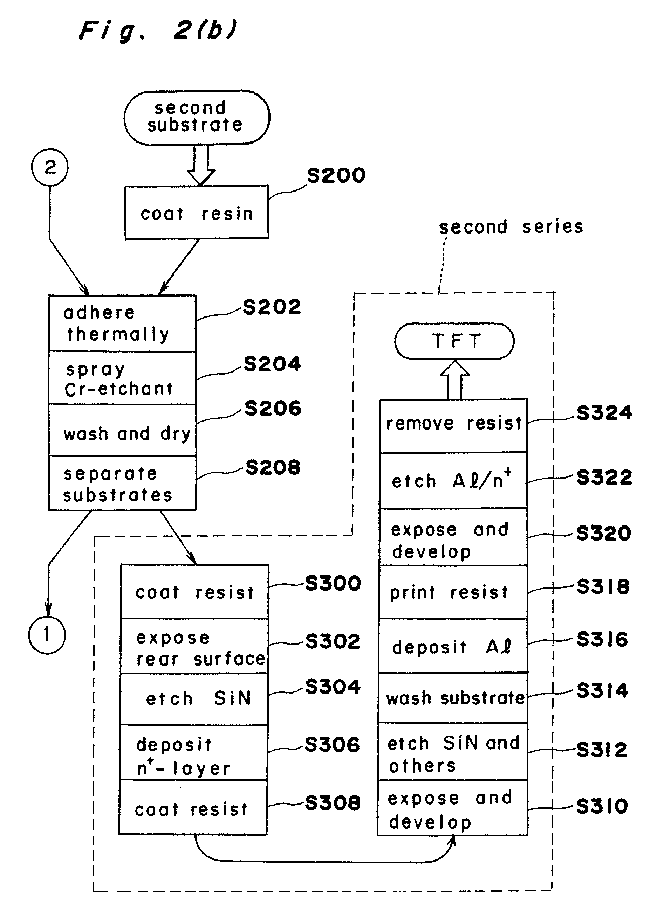

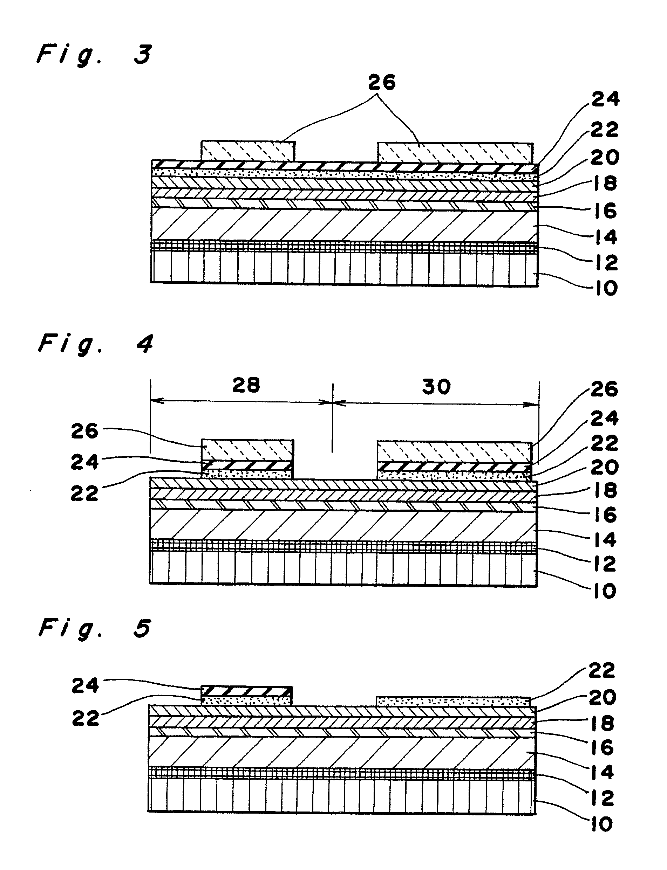

Figures 2(a) and 2(b) show a flowchart of the steps consisting of two series of steps; the first series of the steps relates to the steps with use of a permeable substrate in which water can permeate, while the second series of the steps relates to those with use of a transparent substrate; and the two series are connected through the steps of changing the substrates. Tough the two series are described separately in Figures 2(a) and 2(b), the steps of changing the substrates can also be considered to belong to both series because the two substrates are related.

In the first series, a metallic layer 12 which has resistance against heat and mechanical forces for subsequent steps is deposited on a permeable substrate 10 made of for example glass fiber or ceramic (Step 100). The permeable substrate 10 has heat resistance of about 500 $^\circ$C for subsequent steps. Water can permeate in the substrate 10 in order to etch the metallic layer 12 by an etchant permeating the metallic layer 12, and the substrate 10 has resistance to the etchant. The metallic layer 12 is used to separate the substrate 10 from thin films to be formed on the substrate 10 in the steps for changing substrates. Thus, the metallic layer 12 is made of a metal such as nickel, chromium or titanium which is inert to semiconductor material and is easily etched. In this embodiment, the metllic layer 12 is made of chromium.

Next, the following layers are deposited successively on the metallic layer 12, as shown in Figure 3: a first silicon nitride (SiN) layer 14 as a protective film of semiconductor layer 16 (Step 102), an i-type hydrogenated amorphous silicon (a-Si:H) layer 16 as a semiconductor layer of TFT (Step 104), a second SiN layer 18 and a $TaO_x$ layer 20 as a gate-insulating film of TFT (Step 106), and an indium-tin-oxide (ITO) layer 22 (Step 108) and an aluminum layer 24 as electrodes (Step 110).

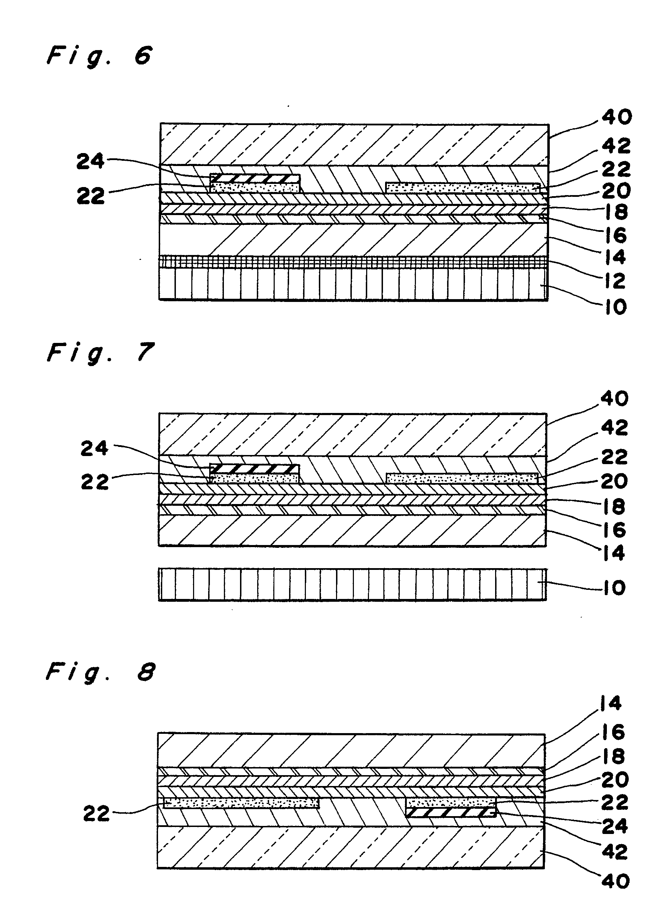

Then, after the substrate 10 becomes cool (Step 112), a resist 26 is coated for minute photolithography processing (Step 114). The resist 26 is exposed with a mask and is developed (Step 116), as shown in Figure 3, to form patterns for gate electrodes in the transistor region 28 (Fig. 4) and for electrodes in the pixel regions 30 (Fig. 4) for transmitting a signal of the TFT.

Next, the aluminum and ITO layers 24, 22 are etched to form electrodes, as shown in Figure 4 (Step 118), and the resist 26 is removed (Step 120).

Further, another resist (not shown) is printed in the transistor region 28 in order to remove the metal, aluminum in this embodiment, which does not transmit light in the transistor region (Step 122). The printing of the resist can be performed at a lower precision because the electrodes in the transistor and pixel regions 28, 30 are already formed with good precision. Next, the aluminum layers 24 in the pixel region 30 are etched (Step 124), and the resist is removed (Step 126), as shown in Figure 5. Then, the substrate 10 is washed and dried (Step 128).

Thus, the first series of processing of thin films by use of the permeable substrate 10 is completed. In the first series, the thin films 14 - 24 are processed on a first principal plane which is the furthest plane from the permeable substrate 10.

Next, thin films 14 - 24 will be processed in the second series on a second principal plane which faces the permeable substrate 10. Before the processing in the second series starts, the substrate for the thin films or for a work to be processed further is changed as will be explained.

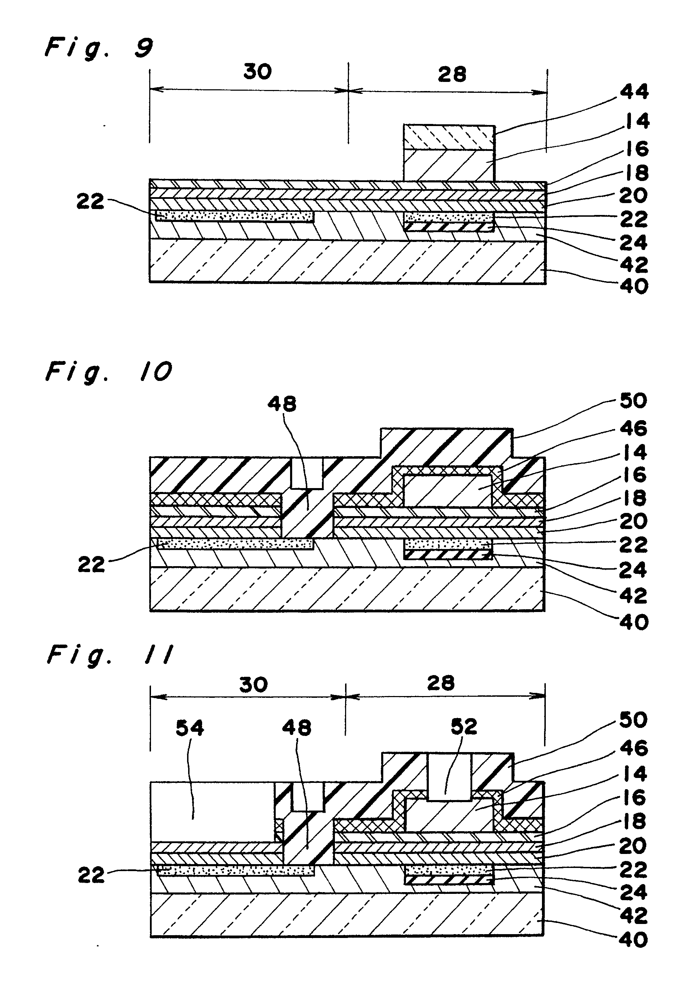

First, a transparent substrate 40 to be used for the second series is washed and dried, and it is coated with an adhesive 42, a thermosetting resin in this embodiment (Step 200). Next, the transparent substrate 40 is adhered to the thin films 14 -24 formed in the first series by putting them between the permeable and transparent substrates 10 and 40 under heating (Step 202), as shown in Figure 6. After the adherance under heating is completed, the metallic layer 12 is sprayed on the permeable substrate 10 so that the etchant easily permeates the substrate 10 to the metallic layer 12 to etch it easily (Step 204), as shown in Figure 7. Then, the substrates 10 and 40 are washed and dried (Step 206), and the permeable substrate 10 is separated from the the thin films formed in the first series. Thus, the thin films are transferred to the transparent substrate 40 as shown in Figure 8 upside down (Step 208). The separated substrate 10 can be used again for the processing in the first series continuously.

In this embodiment, a transparent substrate 40 is used. However, an appropriate support can be used instead of the transparent substrate 40. For example, a thermosetting resin such as an epoxy resin may be coated on the first principal plane and be hardened to support the thin films.

After the transparent substrate 40 is wshed and dried, the processing of the second series starts. First, a resist 44 is coated on the first SiN layer 14 (Step 300). Next, light is irradiated from the side of the transparent substrate 40 to expose the resist 44 by using the aluminum layer 24 as a mask (Step 302). This exposure from the rear side requires that the substrate 40 be transparent. Then, the first SiN layer 14 is etched selectively (Step 304) as shown in Figure 9. After the resist 44 is removed, an $n^+$-type hydrogenated amorphous silicon (a-Si:H) layer 46 is deposited on the first SiN layer 14 and the i-type a-Si:H layer 16 (Step 306). Then, a resist (not shown) is coated (Step 308), and the resist is exposed and developed in order to open a contact window 48 (Step 310). Next, the $n^+$- and i-type a-Si:H layers 46, 16, the second SiN layer 18 and the $TaO_x$ layer 20 are etched to open the contact window 48 (Step 312). Then, the substrate 40 is washed (Step 314), and a second aluminum layer 50 is deposited for source and drain electrodes (Step 316), as shown in Figure 10.

Next, a resist (not shown) is printed on the second aluminum layer 50 (Step 318). The resist can be coated by a simple technique such as printing because the channel length of the TFT is already determined by the first SiN layer 14. Then, the resist is exposed and developed (Step 320), and the second aluminum layer 50 and $n^+$-type a-Si:H layer 46 are etched (Step 322) to separate the source and drain electrodes in the transistor regions 28 with a hole 52 and to have a space 54 for pixels in the pixel regions 30. Next, the resist is removed, as shown in Figure 11 (Step 324). Thus, the second series of processing is completed, and a TFT array on the transparent substrate 40 is produced.

In the above-mentioned embodiment, there are five steps which use a resist, and the exposure which needs precise setting of a mask is only at step 310 for opening a contact window 48. Further, the deposition of thin films which constitute a TFT can be performed continuously and on a surface having small irregularities, so that the local change in the film thickness is small. Thus, electrostatic breakdown nearly occurs and dust hardly remains in a TFT array manufactured as mentioned above.

The manufacturing method according to the present invention explained above is not a batch process essentially, and a semiconductor device can be manufactured continuously.

According to the present invention, two principal planes of the thin films are processed separately, so that the number of the steps per principal plane decreases practically by half. The difference in level of device becomes smaller according to the decrease in the number of the steps, so that the positioning of a mask to the substrate becomes easier. Further, the probability of the generation of dust and damage also is reduced thereby decreasing the probabilty of producing inferior devices.

This invention may be embodied in still other ways without departing from the spirit or essential character thereof. The embodiment described herein is therefore illustrative and not restrictive, the scope of the invention being indicated by the appended claims and all variations which come within the meaning of the claims are intened to be embraced therein.

## Claims

1. A method for manufacturing a semiconductor device which comprises the following steps:

(a) providing a first substrate,

(b) depositing at least one thin film on the first substrate,

(c) processing a first principal plane of the at least one thin film, the first principal plane being further from the first substrate than a second principal plane which faces the first substrate,

(d) adhering a support to the first principal plane of the at least one thin film,

(e) removing the first substrate from the at least one thin film adhered to the support, and

(f) processing the at least one thin film on the second principal plane.

2. The method according to Claim 1, wherein a metallic layer which is inert to the semiconductor device and is etchable is arranged between the first substrate and the second principal plane of said at least one thin film formed on the first substrate, said first substrate being permeable to an etchant for the metallic layer and having corrosion resistance to the etchant.

3. The method according to Claim 1, wherein the support is a second substrate.

4. The method according to Claim 3, wherein the second substrate is transparent.

5. The method according to Claim 1, wherein said support is made from a theremosetting resin.

6. A composite structure for use in manufacturing a thin film semiconductor device which comprises

(a) a porous substrate,

(b) a metallic layer on said porous substrate, and

(c) at least one thin film on said metallic layer, said porous substrate being permeable to an etchant for said metallic layer.

## Fig. I

```
          ┌──────────────┐
          │    first     │
          │  substrate   │
          └──────────────┘
                  │
                  ▼
          ┌──────────────────────────────┐          S10
          │  processing the first        │
          │  principal plane of thin     │
          │  films                       │
          └──────────────────────────────┘        ┌──────────────┐
                  │                                │   second     │
                  │                                │  substrate   │
                  │                                └──────────────┘
                  │                                        │
                  ▼                                        ▼
          ┌──────────────────────────────┐          S20
          │                              │
          │   exchange  of  substrates   │
          │                              │
          └──────────────────────────────┘
                  │
                  ▼
          ┌──────────────────────────────┐          S30
          │  processing the second       │
          │  principal plane of thin     │
          │  films                       │
          └──────────────────────────────┘
                  │
                  ▼
          ┌──────────────┐
          │    T F T     │
          └──────────────┘
```

5

# Fig. 2(a)

```
                      ┌──────────┐
                      │  first   │◀══════════════ ( 1 )
                      │ substrate│◀═══════════
                      └────┬─────┘
                           ║
                    ┌──────▼───────┐
                    │  deposit Cr  │── S100
                    ├──────────────┤
                    │ deposit SiN  │── S102 ········ first series
                    ├──────────────┤
                    │   deposit    │── S104
                    │   i-layer    │
                    ├──────────────┤
                    │   deposit    │── S106
                    │  SiN, TaOx   │
                    ├──────────────┤
                    │ deposit ITO  │── S108
                    ├──────────────┤                    ( 2 )
                    │  deposit Aℓ  │── S110              ▲
                    ├──────────────┤                    ║
                    │cool substrate│── S112       ┌──────┴──────┐
                    ├──────────────┤              │ wash and dry│── S128
                    │ coat resist  │── S114       ├─────────────┤
                    ├──────────────┤              │remove resist│── S126
                    │ expose and   │── S116       ├─────────────┤
                    │  develop     │              │   etch Aℓ   │── S124
                    ├──────────────┤              ├─────────────┤
                    │ etch Aℓ/ITO  │── S118       │ print resist│── S122
                    ├──────────────┤              └──────▲──────┘
                    │remove resist │── S120              │
                    └──────┬───────┘                     │
                           └─────────────────────────────┘
```

6

## *Fig. 2(b)*

second
substrate

② → coat resin ← S200

second series

adhere thermally ← S202

spray Cr-etchant ← S204

wash and dry ← S206

separate substrates ← S208

①

T F T

remove resist ← S324

etch $A\ell/n^+$ ← S322

expose and develop ← S320

print resist ← S318

deposit $A\ell$ ← S316

wash substrate ← S314

etch SiN and others ← S312

expose and develop ← S310

coat resist ← S300

expose rear surface ← S302

etch SiN ← S304

deposit $n^+$-layer ← S306

coat resist ← S308

*Fig. 3*

26

24
22
20
18
16
14
12
10

*Fig. 4*

28    30

26
24
22
26
24
22
20
18
16
14
12
10

*Fig. 5*

24
22
22
20
18
16
14
12
10

**Fig. 6**

**Fig. 7**

**Fig. 8**

*Fig. 9*

*Fig. 10*

*Fig. 11*